# EUROPÄISCHE PATENTSCHRIFT

(11) **EP 1 466 026 B1**
(45) Veröffentlichungstag und Bekanntmachung des Hinweises auf die Patenterteilung: **17.10.2007**
(21) Anmeldenummer: 02785356.3
(22) Anmeldetag: 02.11.2002
(51) Int. Cl.: C22C 9/00, C22F 1/00, C22F 1/08, C30B 29/52, C30B 29/60, C30B 33/02

(54) **SUPERELASTISCHES BAUELEMENT AUS EINER KUPFERLEGIERUNG UND VERFAHREN ZUM EINPRÄGEN UND KONSERVIEREN EINER KRÜMMUNG VORGEGEBENER GEOMETRIE**
SUPERELASTIC ELEMENT MADE OF A COPPER ALLOY AND METHOD FOR IMPARTING AND PRESERVING A CURVATURE OF A GIVEN GEOMETRY
ELEMENT CONSTITUTIF SUPERELASTIQUE EN ALLIAGE DE CUIVRE ET PROCEDE POUR IMPRIMER ET PRESERVER UNE COURBURE DE GEOMETRIE PREDEFINIE

(30) Priorität: 19.12.2001 DE 10162296
(43) Veröffentlichungstag der Anmeldung: 13.10.2004
(73) Patentinhaber: Forschungszentrum Karlsruhe GmbH, 76133 Karlsruhe (DE)
(72) Erfinder: BRHEL, Klaus-Peter, 76356 Weingarten (DE); FISCHER, Harald, 76356 Weingarten (DE)
(86) Internationale Anmeldenummer: PCT/EP2002/012230
(87) Internationale Veröffentlichungsnummer: WO 2003/052150

(56) Entgegenhaltungen:
- WO-A-96/24086
- WO-A-98/53359
- PATENT ABSTRACTS OF JAPAN vol. 2000, no. 16, 8. Mai 2001 (2001-05-08) & JP 2001 020026 A (ISHIDA KIYOHITO;ISHII YOSHIICHI), 23. Januar 2001 (2001-01-23)
- PATENT ABSTRACTS OF JAPAN vol. 1995, no. 06, 31. Juli 1995 (1995-07-31) & JP 07 062472 A (KIYOHITO ISHIDA;OTHERS: 01), 7. März 1995 (1995-03-07)
- PATENT ABSTRACTS OF JAPAN vol. 009, no. 036 (C-266), 15. Februar 1985 (1985-02-15) & JP 59 179771 A (SUMITOMO DENKI KOGYO KK), 12. Oktober 1984 (1984-10-12)

## Beschreibung

Die Erfindung betrifft ein Verfahren zum Einprägen und Konservieren mindestens einer ebenen oder räumlichen Krümmung vorgegebener Geometrie in ein stab- oder bandförmiges Halbzeug aus einer superelastischen, einkristallinen Cu-Legierung.

In PATENT ABSTRACTS OF JAPAN vol. 2000, no. 16, 8. Mai 2001 (2001-05-08) & JP 2001 020026 A und dem Familienmitglied US-A-6 406 566 werden ein superelastisches Bauelement auf Cu-Basis mit mindestens einer Krümmung beschrieben, beispielsweise eine Feder. Insbesondere ist darin ein Verfahren zur Herstellung eines superelastischen Bauteils aus einer Cu-Legierung mit eingeprägter Krümmung vorgestellt, welches einkristallin sein kann.

In der WO 96 24086 A ist insbesondere aus der Zusammenfassung und den Abbildungen 4 und 6 ein superelastisches einkristallines Bauelement mit mindestens einer Krümmung bekannt, insbesondere auch Bauteil 3. Die Krümmung ist nicht plastisch eingeprägt.

In der WO 98 53359 ist in der Zusammenfassung und der Abbildung mit den Bauteilen 2, 3, 6 ein superelastisches polykristallines Bauelement mit mindestens einer Krümmung beschrieben, die durch Warmformung hergestellt werden kann.

In PATENT ABSTRACTS OF JAPAN vol. 009, no. 036 (C-266), 15. Februar 1985 (1985-02-15) & JP 59 179771 A wird ein superelastisches Bauelement aus Single-Beta-Phase vorgestellt mit einer durch Warmformung herbeigeführten, vorbeschriebenen Form, was eine Krümmung sein kann.

Superelastische, einkristalline Cu-Legierungen weisen eine hohe Elastizität auf. Sie übertreffen die bekannten superelastischen NiTi-Legierungen in der Elastizität. NiTi-Legierungen weisen etwa eine superelastische Dehnung von bis zu 8% auf. Die Superelastizität von Ni-Ti-V-Legierungen demonstriert sich eindrücklich an daraus zumindest teilweise hergestellten Brillengestellen (siehe hierzu beispielsweise DE 689 03 293 T2 oder EP 0 310 628 B1). Ein gerades Halbzeug wie ein Stab beispielsweise aus einer superelastischen, einkristallinen Cu-Legierung bringt es dagegen bis auf 20%.

Diese ausgezeichnete, superelastische Eigenschaft ist bekannt, lässt sich aber bisher nur am linearen Draht oder Stab vorführen. Es ist noch nicht gelungen, solch einem geraden Halbzeug eine vorgegebene Krümmungsgeometrie mit der Eigenschaft der Superelastizität einzuprägen.

Diese bisher noch nicht gelöste Aufgabe, nämlich ein alternatives Herstellungsverfahren zur Herstellung superelastischer einkristalliner gekrümmter Bauteile aus einer Cu-Legierung aus einem geraden Halbzeug zu finden, liegt der Erfindung zugrunde.

Die Aufgabe wird durch ein Verfahren mit den in Anspruch 1 gekennzeichneten Verfahrensschritten gelöst. Das Verfahren zur Herstellung dieser Bauelemente besteht aus folgenden Schritten (Anspruch 1) :

Das zu biegende Halbzeug wird auf eine Biegetemperatur zwischen 700 und 900°C erwärmt.

Das Werkzeug aus für den Prozess thermisch belastbarem Material hat eine exponierte Front, in der die Geometrie der Krümmung abgedrückt ist. Es wird gleichzeitig bis höchstens zur Biegetemperatur erwärmt, bei der dem anzulegenden und zu biegenden Halbzeug die vorgesehene Krümmung sukzessive bruchfrei über die Länger der exponierten Front eingeprägt wird.

Nach vollendetem Einprägen der vorgegebenen Krümmungsgeometrie kühlt die Struktur ab und wird der Biegevorrichtung entnommen.

Bei dieser Formgebung unter Temperatureinfluss wird das einkristalline Gefüge im Biegungsbereich gestört, so dass nach anschließender Abkühlung in diesem Krümmungsbereich keine Superelastizität mehr besteht. Zur Wiederherstellung der beim Erwärmen und Biegen verlorengegangenen Superelastizität wird der auf Umgebungstemperatur abgekühlte Prozessgegenstand in einem auf eine Temperatur von 750 bis 900°C vorgeheizten Ofen geglüht. Die Superelastizität ist jetzt wieder eingestellt und wird im folgenden Schritt eingefroren, und zwar wird das Bauelement nach der Glühzeit entnommen und unverzüglich in einem Kühlmedium, das nur Kühlfunktion hat, abgeschreckt.

Es zeigt sich, dass beim Glühen über wenigstens ½ Stunde die Superelastizität sicher restauriert werden kann, allerdings lässt sie sich beim Glühen bis nur zu einer Stunde nur sehr begrenzt konservieren, d.h. je nach Beanspruchung nur bis zu etwa 3 Monaten. Längere Glühzeiten, über eine Stunde bzw. erheblich drüber, konservieren die Superelastizität ganz erheblich länger. Der Zusammenhang ist nicht linear.

Beim Einprägen der vorgeschriebenen Krümmungsgeometrie beträgt beispielsweise die Biegetemperatur während des Einprägens 850°C nach Anspruch 2. Für den zweiten thermischen Prozessionsschritt ist dazu der Ofen auf 850°C vorgeheizt (Anspruch 3).

Die Flüssigkeit des Kältebads ist ein Medium, das lediglich zur thermischen Abschreckung und Einrichtung der Superelastizität dient. Es reagiert chemisch mit dem Bauelementmaterial nicht und soll das auch nicht, da die Oberfläche durch diesen Vorgang nicht konditioniert werden soll. Nach Anspruch 4 ist Wasser als Abschreckmedium in flüssiger Form geeignet. Wasser von Raumtemperatur erfüllt somit die Abschreckfähigkeit hinreichend.

Die Krümmung kann in einer Ebene liegen, räumlich sein oder eine Zusammensetzung aus solchen Teilkrümmungen sein.

Das Bauteil ist an seiner Oberfläche behandelt, aus zweckmäßigen oder aus ästhetischen Gründen. Hierzu ist es je nachdem mit einer metallischen Schicht/Haut überzogen, das kann Gold oder sonst ein edles Metall sein. Es kann aber auch ein dielektrisches wie ein Polymer oder ein keramisches Material sein, solange es so dünn bleibt, dass die Superelastizität nicht beeinträchtigt wird und bei Biegevorgängen auch im stärksten Krümmungsbereich nicht platzt.

Werden solche Bauteile im medizinischen/klinischen Bereich verwendet muss auf jeden Fall die exponierte Oberfläche inert oder gewebeverträglich gegen die berührende, anliegende Umgebung sein. Schichtkombinationen kommen, sofern sie nicht reißen und die Superelastizität nicht beeinträchtigen, ebenfalls in Frage.

Beispiel für die Verwendung solchermaßen gefertigter Bauteile ist ein Brillengestell, das ganz oder zumindest in Teilen wie Bügel und Nasensteg daraus gefertigt ist.

Ein mit einem derartigen Verfahren hergestelltes Bauelement mit diesen außergewöhnlich elastischen Eigenschaften, hat vielfältige Einsatzgebiete, da eine eingeprägte, verhältnismäßig raumgreifende Gestalt beispielsweise über diese superelastische Eigenschaft sehr flach und schmal zusammengelegt werden kann, um bei Wegnahme der äußeren Zwangskräfte wieder in die eingeprägte Form aufzuspringen. Zur Anschauung seien unvollständig die folgenden Gegenstände als exemplarische Bauelemente/Erzeugnisse genannt: Brillengestell, Zug- und Druckfeder, Verhütungsspirale, Arterienstopper, Kraftbegrenzer in Zangengriffen.

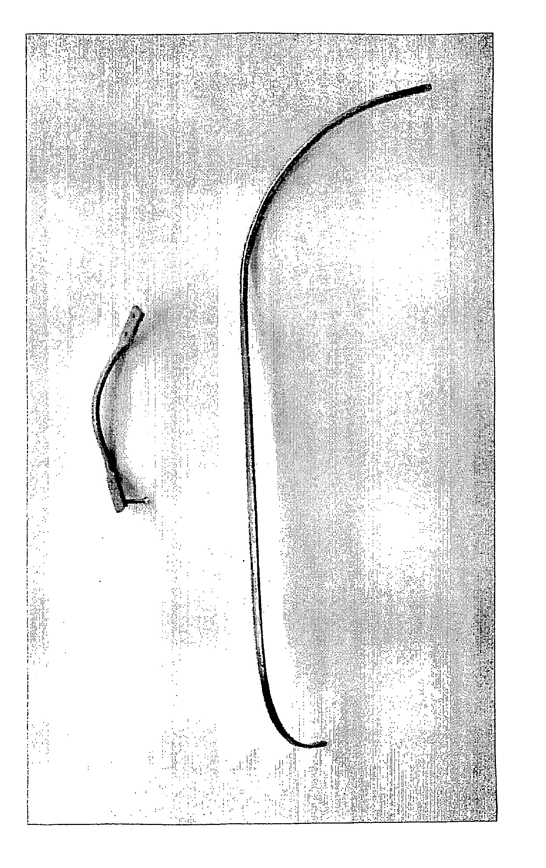

Die Erfindung wird im Folgenden anhand eines Durchführungsbeispiels in Form eines superelastischen Brillengestells, das aus einer solchen formgeprägten superelastischen Cu-Legierung besteht, näher beschrieben. Die Zeichnung besteht aus der Figur 1, die einen Bügel und Nasensteg der Brille aus dem superelastischen Material zeigt. Die Superelastizität muss beim Bügel über die gesamte Länge insbesondere an der kleineren Krümmung bestehen. Der Bügel setzt mit seinem Ende an der starken Krümmung direkt am zugehörigen Brillenglas oder dessen Rahmen an. Die große Krümmung des Bügels liegt überm Ohr des Trägers.

Hohe Elastizität braucht aber auch der Nasenbügel, der beide Brillengläser verbindet. Beispielsweise wird dieser Nasenbügel an seinen beiden Enden mit jeweils zwei Bohrungen an je ein Brillenglas bzw. dessen Rahmen geschraubt, so dass beide Gläser im aufgeklappten als auch im aufeinandergelegten Zustand stets fest miteinander gekoppelt sind.

Im zusammengeklappten Zustand müssen beide Bügel über die jeweils gesamte Länge superelastisch sein, da diese willkürlich mit zusammengelegt werden, bis die vom Träger gewünschte Brillenfaltung zum Einpacken besteht. Zentrale, nicht faltbare, und damit kleinste, in ihrer Form unveränderbare Fläche ist bei der Brille die jeweilige Fläche ihrer beiden Brillengläser.

Das Verfahren wird, da noch in der Untersuchungsphase, derzeit noch von Hand durchgeführt. Zur Herstellung des Brillenbügels und des Nasenstegs wurde ein schweißdrahtförmiges Halbzeug mit kreisförmigem Querschnitt verwendet. Das gelieferte Halbzeug ist pro Stab 1,5 mm dick und 350 mm lang. Bezogen wurde es von der Firma Memory Metalle GmbH in 79567 Weil am Rhein. Nach Lieferscheinangabe handelt es sich um einen CuAlNiFe-Einkristall der angegebenen Geometrie. Eine Quantifizierung der Anteile ist daraus nicht zu entnehmen, ein Datenblatt steht nicht zur Verfügung.

Das Einprägeverfahren im Durchführungsbeispiel läuft folgendermaßen ab:

Das einkristalline Halbzeug in dünner Stabform mit 1,5 mm Durchmesser wird an einem Ende in einer schwenkbaren, auf einer Grundplatte verankerten Greifvorrichtung eingeklemmt und gehalten. In gerader Entfernung sitzt ebenfalls auf der Grundplatte eine andere, starre Klemmvorrichtung, in die der Draht ebenfalls eingeklemmt ist. Mindestens der Krümmungsbereich liegt zwischen beiden Spannvorrichtungen eingespannt.

Das Biegewerkzeug ist in einer Halterung eingespannt, die ebenfalls auf der Grundplatte verankert ist. Das Biegewerkzeug ist aus einem massiven Vierkantmaterial aus Edelstahl oder Kupfer, das während aller Prozessbedingungen formstabil bleibt. Es kann ein anderes metallisches Material sein, sofern es für den Prozess thermisch geeignet ist. Das Biegewerkzeug hat eine exponierte frei zugängliche Stirn, in die die Krümmungsgeometrie in Form einer Einlegenut eingearbeitet ist. Der eingespannte Halbzeugbereich und das Biegewerkzeug sind je an einen Stromkreis angeschlossen, so dass beide Teile voneinander unabhängig stromgeregelt erwärmt werden können. Die Temperatur des eingespannten Halbzeugs und des Werkzeugs werden an maßgebender Stelle mit je einem Thermofühler abgetastet.

Hier ist die angestrebte Krümmung einfach und eben. Das eingespannte Drahtstück und die Biegelehre liegen daher in einer Ebenen, der Schwenkebene.

Während der Erwärmung liegen beide Teile, eingespanntes Drahtstück und Biegelehre, nahe jedoch noch berührungslos zueinander. Beide Stromkreise werden geschlossen und dadurch erwärmt. Die Biegelehre muss mindestens 650°C warm sein, um eine zu rasche Abkühlung des angelegten Drahtstücks zu vermeiden, und hat höchstens die Biegetemperatur für den Draht von hier 850°C. Befindet sich die Biegelehre im vorgeschrieben Temperaturbereich und ist das eingespannte Drahtstück im Krümmungsbereich auf Biegetemperatur, dann wird der Draht in die Krümmungsform gezogen, und bei vollem Einliegen beide Stromkreise abgeschaltet. Beide Gegenstände kühlen natürlich ab. Die Krümmungsgeometrie ist eingeprägt. Nach Verschwinden der Rotglut wird der Draht ausgespannt und kühlt vollends natürlich ab.

Der folgende Verfahrensschritt restauriert die Superelastizität. Dazu wird der Draht in den auf 850°C vorgewärmten Ofen gelegt und 12 Stunden bei dieser Temperatur geglüht.

Nach dem Glühvorgang wird der Draht entnommen und sofort in Wasser, das Umgebungstemperatur hat, abgeschreckt. Jetzt hat der Draht die vorgesehene Krümmungsgeometrie zusammen mit der superelastischen Eigenschaft über seine gesamte Drahtlänge erlangt und dauerhaft konserviert. Das Bauelement kann seine vorgesehene Funktion erfüllen.

Der Krümmungsradius kann höchstens so klein gemacht werden, dass der Querschnitt des Halbzeugs sich bei der Biegung in die vorgesehene Krümmung nicht nennenswert ändert, d.h. es darf im Krümmungsbereich nicht zu Materialfließprozessen kommen, sie zerstören das Material-/Kristallgefüge irreparabel. Bei bandförmigem Halbzeug ist entsprechend die Banddicke in Beachtung zu setzen.

Prototypisch wurde so eine Sonnenbrille gefertigt, bei der beide superelastischen Bügel und der superelastische Nasensteg unmittelbar mit ihren jeweiligen Enden an die Gläser angeschraubt sind. Die Brille ist seit vier Monaten in ständiger Testhandhabe und weist unverändert die außergewöhnliche Zusammenlegbarkeitseigenschaft auf.

Die Einsatzmöglichkeit der Bauelemente aus diesem superelastischem, einkristallinen Cu-Legierung ist beispielhaft und dient nur der Veranschaulichung des Einprägens einer Krümmung und der Wiederherstellung der Superelastizität in dem Material des Bauelements, ist aber in keiner Weise auf die Fertigung eines Brillengestells beschränkt.

## Patentansprüche

1. Verfahren zum Einprägen und Konservieren mindestens einer ebenen oder räumlichen Krümmung vorgegebener Geometrie in ein stab- oder bandförmiges Halbzeug aus einer superelastischen, einkristallinen Cu-Legierung,
bestehend aus den Schritten:
das zu biegende Halbzeug wird auf eine Biegetemperatur zwischen 700 und 900°C erwärmt,
ein Werkzeug aus für den Prozess thermisch belastbarem Material, in dem die Geometrie der Krümmung abgedrückt ist, wird gleichzeitig auf höchstens die Biegetemperatur erwärmt, bei der dem anzulegenden und zu biegenden Halbzeug die vorgesehene Krümmung sukzessive bruchfrei eingeprägt wird,
nach vollendeter Einprägen der vorgegebenen Krümmungsgeometrie kühlt die Struktur ab und wird der Biegevorrichtung entnommen,
zur Wiederherstellung der beim Erwärmen und Biegen verlorengegangenen Superelastizität wird das auf Umgebungstemperatur abgekühlte Bauelement in einem auf eine Temperatur von 750 bis 900°C vorgeheizten Ofen mindestens 1 Stunde geglüht,
danach wird das Bauelement entnommen und unverzüglich in einem Kühlmedium abgeschreckt.

2. Verfahren nach Anspruch 1, bei dem die Biegetemperatur 850°C beträgt.

3. Verfahren nach Anspruch 1 oder 2, bei dem der Ofen zum Glühen auf 850°C aufgeheizt ist und das Bauelement bei dieser Temperatur geglüht wird.

4. Verfahren nach den Ansprüchen 1 bis 3, bei dem das Kühlmedium Wasser ist.

## Claims

1. Process for embossing into and preserving at least one plane or spatial curvature of given geometry in a rod- or band-shaped semi-finished product made of a superelastic, monocrystalline Cu alloy,
consisting of the following steps:
The semi-finished product to be bent is heated up to a bending temperature between 700 and 900°C,
a tool made of a thermally stable material and provided with the geometry of the curvature is simultaneously heated up to the bending temperature at the maximum, at which the curvature is embossed successively and without any cracks into the semi-finished product to be applied and to be bent,
after embossing of the given curvature geometry, the structure is cooled down and removed from the bending facility,
to restore the superelasticity lost during heating and bending, the construction element cooled down to ambient temperature is annealed for at least one hour in a furnace pre-heated to a temperature of 750 to 900°C,
then the construction element is removed and quenched immediately in a cooling medium.

2. Process according to Claim 1, with the bending temperature amounting to 850°C.

3. Process according to Claim 1 or 2, with the furnace for annealing being heated up to 850°C and the construction element being annealed at this temperature.

4. Process according to Claims 1 through 3, with the cooling medium being water.

## Revendications

1. Procédé permettant de conférer par empreinte et de conserver en l'état une courbure plane ou spatiale de géométrie prédéterminée à un produit semi-fini en barre ou feuillard composé d'un alliage de cuivre monocristallin superélastique,
comprenant les étapes de :
réchauffer le produit semi-fini à plier à une température de pliage comprise entre 700 et 900°C ;
amener simultanément un outil constitué d'un matériau capable de résister à la température de process et comportant l'empreinte de la géométrie de courbure à réaliser à la température de pliage permettant de conférer, progressivement et sans rupture, au produit semi-fini à insérer et à plier la courbure prévue ;
laisser refroidir la structure après achèvement de l'opération d'empreinte de la courbure prédéterminée et la sortir du dispositif de pliage ;
afin de restaurer au matériau la superélasticité perdue durant l'opération de chauffage et de pliage, procéder au recuit de l'élément refroidi à température ambiante dans un four préchauffé entre 750 et 900°C pendant au moins une heure ;
extraire ensuite l'élément du four et le refroidir immédiatement dans un milieu réfrigérant.

2. Procédé selon la revendication 1 **caractérisé en ce que** la température de pliage est de 850°C.

3. Procédé selon la revendication 1 ou 2 **caractérisé en ce que** le four de recuit est chauffé à 850°C et que l'élément est recuit à cette température.

4. Procédé selon les revendications 1 à 3 **caractérisé en ce que** le milieu réfrigérant est de l'eau.
